# FASCICULE DE BREVET EUROPEEN

(11) **EP 3 954 247 B1**
(45) Date de publication et mention de la délivrance du brevet: **24.05.2023**
(21) Numéro de dépôt: 20190569.2
(22) Date de dépôt: 11.08.2020
(51) Int. Cl.: A44C 17/02, G04B 45/00, C23C 14/00, G04B 19/12, G04D 3/00

(54) **COMPOSANT NOIR DECORE DE PIERRES ET SON PROCEDE DE FABRICATION**
MIT STEINEN VERZIERTE SCHWARZE KOMPONENTE UND IHR HERSTELLUNGSVERFAHREN
BLACK COMPONENT DECORATED WITH STONES AND METHOD FOR MANUFACTURING SAME

(43) Date de publication de la demande: 16.02.2022
(73) Titulaire: Omega SA, 2502 Biel/Bienne (CH)
(72) Inventeur: JEANRENAUD, Frédéric, 2300 La Chaux-de-Fonds (CH); KISSLING, Gregory, 2520 La Neuveville (CH); LAUPER, Stéphane, 2016 Cortaillod (CH); MARLOT DOERR, Agnès, 2000 Neuchâtel (CH); MIKO, Csilla, 1417 Essertines-sur-Yverdon (CH)
(74) Mandataire: ICB SA

(56) Documents cités:
- EP-A1- 1 522 606
- EP-A1- 3 327 517
- EP-B1- 3 327 517
- CH-A1- 709 669
- CH-A2- 711 141
- CH-B1- 709 669

## Description

### Domaine de l'invention

L'invention se rapporte à un composant destiné à l'habillage intérieur ou au mouvement d'une pièce d'horlogerie ou de bijouterie. Elle se rapporte également au procédé de fabrication dudit composant.

### Arrière-plan de l'invention

La « couleur » noire peut être obtenue dans la masse d'un matériau de par sa couleur intrinsèque ou via l'ajout de pigments ou colorants au sein du matériau. La «couleur» noire peut également être présente uniquement en surface. Cette coloration en surface peut être obtenue de différentes manières, généralement par oxydation/sulfuration/carburation d'un substrat métallique ou par dépôt d'un oxyde/sulfure/carbure sur un substrat. Le carbone est donc un élément bien connu pour noircir une surface. Déposé de manière longiligne sous forme de nanotubes, le matériau formé peut s'approcher d'un corps noir parfaitement absorbant allant jusqu'à donner des coefficients d'absorption de lumière de 99,96% dans le visible et proche infrarouge. Ce noir est si parfait qu'il peut cacher des formes 3D d'un objet vu de face.

L'utilisation de revêtement noir est connue dans le domaine horloger. Du document EP 3 327 517, on connait un cadran avec un premier substrat revêtu d'une couche noire de nanotubes faisant face au verre de montre et avec un deuxième substrat fixé au premier substrat sur la surface opposée au verre. Le premier substrat est ajouré afin de réaliser des ouvertures faisant office de fenêtres destinées à former des index. Le deuxième substrat comprend un revêtement luminescent au moins dans les zones en regard des ouvertures de manière à créer un contraste au niveau du premier substrat entre la couche noire et les index illuminés.

Ainsi, le contraste est obtenu via la superposition de deux substrats présentant des revêtements distincts. Cette superposition permet d'éviter de déposer de manière sélective l'un et l'autre revêtement sur une même surface et de manipuler plus que nécessaire la couche de nanotubes qui est particulièrement fragile. Cette superposition a néanmoins pour inconvénient de requérir la fabrication de deux substrats ce qui augmente les coûts de production.

Du document CH 711 141, on connaît un procédé de fabrication d'un cadran où le décor, à savoir des index, est apposé sur le revêtement en noir de carbone. Le décor est fabriqué séparément du cadran et ensuite simplement rapporté ce qui permet de faciliter grandement la fabrication du cadran. Cette technique de fabrication est cependant inadaptée pour certains types de décors où la couleur noire sous-jacente au décor impacte l'esthétique et/ou la brillance du décor.

En particulier, cette technique de fabrication est peu adaptée pour un décor formé de pierres, en particulier de diamants. La difficulté réside dans le sertissage des pierres sur le cadran revêtu d'une couche noire. Cette dernière doit être discontinue au niveau des pierres sous peine de dégrader la brillance des pierres, tout en enrobant parfaitement les pierres pour obtenir le contraste escompté. Une attention particulière doit être portée au procédé de fabrication pour ne pas endommager la couche de nanotubes de carbone. La couche peut être à ce point friable qu'il est quasi impossible de la toucher sans dégrader la surface, montrant des voiles brillants voire des trous contrastant avec la couleur originale des nanotubes de carbone. Il existe encore les documents CH709669 et EP1522606 qui divulguent des composants horlogers revêtus de couche noire.

### Buts de l'invention

Le but de la présente invention est de proposer un procédé de fabrication d'un composant horloger ou de bijouterie revêtu de noir et décoré de pierres, et plus particulièrement serti de pierres. Ce procédé est mis au point de manière à ne pas endommager le revêtement noir tout en ayant une couche noire discontinue au niveau des pierres.

Le procédé de fabrication selon l'invention ne peut ainsi se contenter de rapporter un décor, en l'occurrence des pierres, sur le revêtement comme selon l'art antérieur. Selon l'invention, le décor formé des pierres est fabriqué directement sur le substrat avec la couche noire déposée sélectivement de manière à maintenir une surface vierge de noir en dessous du décor.

Plus précisément, l'invention se rapporte à un procédé de fabrication d'un composant destiné à l'habillage intérieur ou au mouvement d'une pièce d'horlogerie ou de bijouterie, ledit composant comportant un substrat revêtu au moins partiellement d'une couche noire comprenant des nanotubes de carbone ou de l'oxyde d'aluminium, le substrat revêtu étant décoré avec au moins une pierre assise dans un logement ménagé dans le substrat, ce dernier étant au moins dépourvu de la couche noire sur la surface du logement, ledit procédé comprenant:
- une étape a) de mise à disposition du substrat,
   suivie dans un ordre non spécifié d'
- une étape b) de dépôt de la couche noire sur le substrat,
- une étape c) d'usinage du logement dans le substrat,
- une étape d) de positionnement et fixation de la pierre au sein du logement,
ladite étape b) de dépôt étant réalisée sélectivement de manière à ce qu'au moins la surface du logement soit dépourvue de la couche noire.

Selon une variante de l'invention, l'étape b) de dépôt sélectif peut être réalisée via le dépôt d'une couche de précurseur favorisant le dépôt de la couche noire à des endroits choisis ou encore via la fixation de plaques revêtues de la couche noire à ces endroits choisis.

La présente invention se rapporte également au composant d'habillage intérieur ou du mouvement pour une pièce d'horlogerie ou de bijouterie comprenant un substrat revêtu partiellement d'une couche noire et décoré d'au moins une pierre assise dans un logement ménagé dans le substrat, ladite couche noire comprenant des nanotubes de carbone ou un oxyde d'aluminium, ledit substrat étant au moins dépourvu de la couche noire sur la portion en regard de la pierre ou, en d'autres mots, sur la surface du logement.

Pour la variante avec un décor de diamants sur un revêtement de nanotubes de carbone, la présente invention propose de réaliser un composant d'horlogerie ou de bijouterie avec en surface deux formes allotropiques du carbone, l'un très noir pour les nanotubes de carbone et l'autre très blanc pour le diamant permettant des contrastes de brillance très marqués.

D'autres caractéristiques et avantages de la présente invention apparaîtront dans la description présentée en référence aux dessins annexés.

### Description sommaire des dessins

La figure 1 est une représentation en plan d'une pièce d'horlogerie munie d'un cadran revêtu et décoré avec des pierres selon le procédé de l'invention. En agrandissement, une pierre avec l'élément de sertissage est représentée.

Les figures 2 à 4 sont des représentations schématiques des différents modes de réalisation du procédé selon l'invention avec les étapes successives mises en oeuvre.

### Description de l'invention

L'invention se rapporte à un composant destiné à l'habillage intérieur ou au mouvement d'une pièce d'horlogerie ou de bijouterie. Il peut être choisi parmi la liste non exhaustive comprenant un cadran, une aiguille, un index, une applique, une masse oscillante, une platine, un pont, etc. Selon l'invention, ce composant est au moins partiellement revêtu d'une couche noire. L'invention se rapporte également à un ensemble de deux desdits composants au moins partiellement revêtus avec la couche noire.

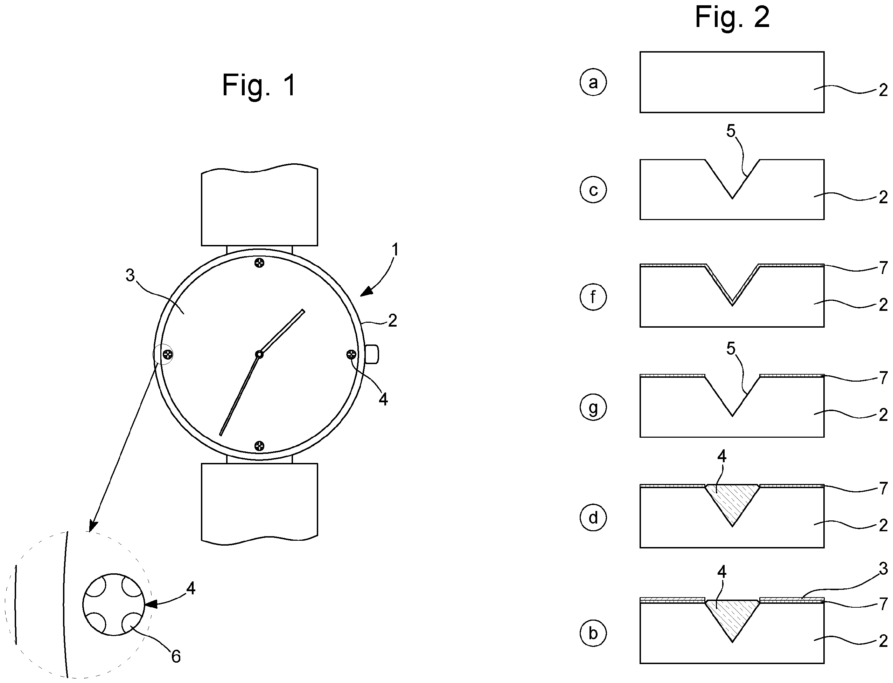

L'invention sera décrite ci-après dans le cadre d'une application à un cadran de montre 1 formé d'un substrat 2 revêtu d'une couche noire 3 tel que schématisé à la figure 1. Ledit substrat peut être réalisé dans un matériau métallique tel que l'acier, le titane, l'aluminium, un alliage de titane ou d'aluminium, le laiton ou tout autre alliage cuivreux. Il peut également être réalisé dans un matériau céramique, un cermet, en saphir, en composite ou dans un polymère. Le substrat 2 est décoré et préférentiellement serti avec une ou plusieurs pierres 4 réparties au sein de la couche noire 3. Il peut s'agir de pierres précieuses telles que le diamant, de pierres semi-précieuses ou encore de pierres synthétiques telles que la zircone, etc. Selon l'invention, le substrat est au moins dépourvu de la couche noire sur les portions en regard des pierres. La couche noire peut être présente de manière à affleurer la table de la pierre. Il est également envisageable de décorer le substrat avec plusieurs alignements de pierres, le substrat comportant une couche noire entre les alignements.

Le substrat 2 comporte un logement 5 schématisé à la figure 2 servant d'assise à la pierre 4 et plus particulièrement à la culasse de la pierre. La fixation de la pierre au sein de l'assise est préférentiellement réalisée par sertissage à l'aide d'un élément de sertissage 6 représenté dans l'agrandissement de la figure 1. Il peut s'agir de griffes d'un chaton disposé dans le logement, de grains qui font partie intégrante du substrat, de saignées dans un logement pour un sertissage baguette ou invisible, etc. Selon l'invention, l'élément de sertissage est préférentiellement également revêtu de la couche noire de manière à réaliser un sertissage qui semble invisible aux yeux de l'utilisateur. Visuellement, celui-ci se fond dans le fond noir du cadran. En alternative, la présente invention n'exclut pas que la pierre soit collée au sein de l'assise avec une colle ne dégradant pas la brillance de la pierre.

Selon une variante de l'invention, la couche noire comporte des nanotubes de carbone. La couche de nanotubes de carbone comporte au moins 1 % en poids, de préférence au moins 10% en poids, de nanotubes de carbone. Ladite couche peut être un vernis comprenant en poids au moins 1 %, de préférence au moins 10% en poids, de nanotubes de carbone. Plus la proportion est importante, plus la teinte est sombre. Dans ce vernis, les nanotubes de carbone sont dispersés aléatoirement. Ce vernis peut être déposé, à titre d'exemple, par sprayage. Alternativement, la couche comporte au moins 50%, au moins 60%, au moins 70%, au moins 80%, au moins 90% en poids de nanotubes de carbone alignés verticalement par rapport au plan du substrat, le reste étant constitué d'autres formes de carbone. De préférence, la couche comporte 100% de nanotubes de carbone alignés verticalement par rapport au plan du substrat. L'alignement vertical des nanotubes permet d'obtenir un noir plus profond par rapport à l'orientation aléatoire des nanotubes de carbone dans le vernis mais présente le désavantage d'avoir une résistance mécanique moindre que le vernis. Pour pallier cet inconvénient, une couche de protection peut être déposée sur la couche noire avec cependant pour corollaire une réduction du coefficient d'absorption de la lumière. La couche de protection peut être un vernis ou une couche mince d'un matériau, par exemple de l'Al₂O₃, du TiO₂ ou du SiO₂, ou un empilement de couches d'un ou plusieurs de ces matériaux déposé par ALD (pour Atomic Layer Déposition). Les nanotubes présentant une orientation verticale sont déposés par des procédés sous vide tels que le PVD (pour Physical Vapor Déposition en anglais), le CVD (pour Chemical Vapor Déposition en anglais) ou encore la synthèse par ablation laser. La couche de nanotubes de carbone a une épaisseur comprise entre 1 et 100 µm.

Selon une autre variante, la couche noire est une couche comprenant majoritairement des oxydes d'aluminium AlₓO_{y} tels que de l'Al₂O₃ avec en complément des oxydes métalliques non ferreux tels que, à titre d'exemple, des oxydes de cuivre, de zinc ou de manganèse. Cette couche comporte au minimum 90% d'AlₓO_{y}, de préférence 100% d'AlₓO_{y}. L'oxyde d'aluminium a une teneur en aluminium comprise entre 45% et 65 % massique et de préférence entre 45% et 50% massique. Cette couche a une épaisseur comprise entre 1 et 50 microns, de préférence entre 2 et 10 microns, et plus préférentiellement entre 4 et 7 microns. Elle peut être déposée par PVD, CVD ou PECVD (pour Plasma-Enhanced Chemical Vapor Déposition en anglais).

Le composant selon l'invention peut être fabriqué selon plusieurs modes de réalisation qui sont illustrés de manière schématique aux figures 2 à 4. Par souci de simplification, les figures 2 à 4 illustrent uniquement le substrat muni d'un logement pour l'assise de la pierre sans représenter l'élément de sertissage. Toute étape faisant état de l'usinage du logement englobe, le cas échéant, la préparation mécanique de l'élément de sertissage tel que les grains.

Le procédé de fabrication du composant comporte dans un ordre non spécifié pour les étapes b) à d):
- Une étape a) de mise à disposition du substrat 2,
- Une étape b) de dépôt de la couche noire 3 sur le substrat 2,
- Une étape c) d'usinage du logement 5 dans le substrat 2,
- Une étape d) de positionnement et de fixation, et préférentiellement de sertissage, de la pierre 4 au sein du logement 5. La fixation couvre le sertissage de manière générale et d'autres techniques de fixation tels que le collage.

Selon l'invention, le dépôt à l'étape b) est réalisé de manière sélective de façon à ce qu'au moins la surface du logement 5 soit dépourvue de la couche noire 3.

Pour les exemples des figures 2 à 4, le procédé de fabrication du composant comprend successivement :
- l'étape a) de mise à disposition du substrat 2,
- l'étape c) d'usinage du logement 5 dans le substrat 2,
- l'étape d) de positionnement et fixation de la pierre 4 au sein du logement 5 du substrat 2,
- l'étape b) de dépôt de la couche noire 3 sur le substrat 2, ladite étape b) de dépôt étant réalisée sélectivement de manière à ce qu'au moins la surface du logement 5 soit dépourvue de la couche noire 3.

Pour la variante de la figure 2, il y a une étape f) additionnelle de dépôt et recuit d'une couche d'un précurseur 7 sur le substrat 2. L'étape f) inclut le dépôt de la couche de précurseur et le recuit pour polymériser le précurseur. Cette variante est d'application pour une couche noire à base de nanotubes de carbone.

Il y a ensuite une étape g) additionnelle d'enlèvement sélectif de la couche de précurseur 7 déposée dans le logement 5. L'enlèvement peut être réalisé mécaniquement et plus spécifiquement manuellement à l'aide d'un outil de sertisseur. Selon une variante préférée, cet enlèvement sélectif est réalisé par ablation laser et plus préférentiellement avec un laser impulsionnel tel qu'un laser picoseconde, nanoseconde ou femtoseconde. Suit alors l'étape d) de positionnement et fixation de la pierre 4 au sein du logement 5 du substrat 2. Finalement, il y a l'étape b) d'apport de la couche noire 3 sur le substrat 2 qui s'effectue sélectivement sur les parties recouvertes de la couche de précurseur 7. De manière alternative (non représentée), l'étape f) peut être réalisée avant l'étape c) d'usinage du logement, les étapes c) et g) étant alors une même étape concomitante d'usinage du logement et d'enlèvement sélectif de la couche de précurseur au niveau du logement. D'une autre manière alternative (non représentée), le dépôt de la couche de précurseur peut être réalisé sur le substrat serti avec la pierre, l'enlèvement sélectif du précurseur étant alors réalisé sur la pierre.

Le précurseur comporte un polymère et des nanotubes de carbone. Le pourcentage en poids de nanotubes de carbone est compris entre 0.1 et 15% et le pourcentage en poids de polymère est compris entre 85 et 99.9%. Le polymère peut être choisi parmi des thermoplastiques tels qu'un polyamide, polybutène, polyéthylène, polyimide, polypropylène, polystyrène, polyacétate de vinyle et un polyméthacrylate de méthyle ou parmi des thermodurcissables tels qu'un polyépoxyde et un polyuréthane. Pour améliorer l'adhésion entre le polymère et les nanotubes de carbone, ces derniers peuvent au préalable être fonctionnalisés. A titre d'exemple, pour une matrice en polyimide, les nanotubes de carbone peuvent être préalablement fonctionnalisés par une attaque en milieu acide, par exemple dans de l'acide nitrique. Le précurseur comprenant le mélange de nanotubes de carbone répartis dans la matrice de polyimide est déposé et polymérisé à une température comprise entre 150 et 350°C pendant un temps compris entre 1 et 7 heures.

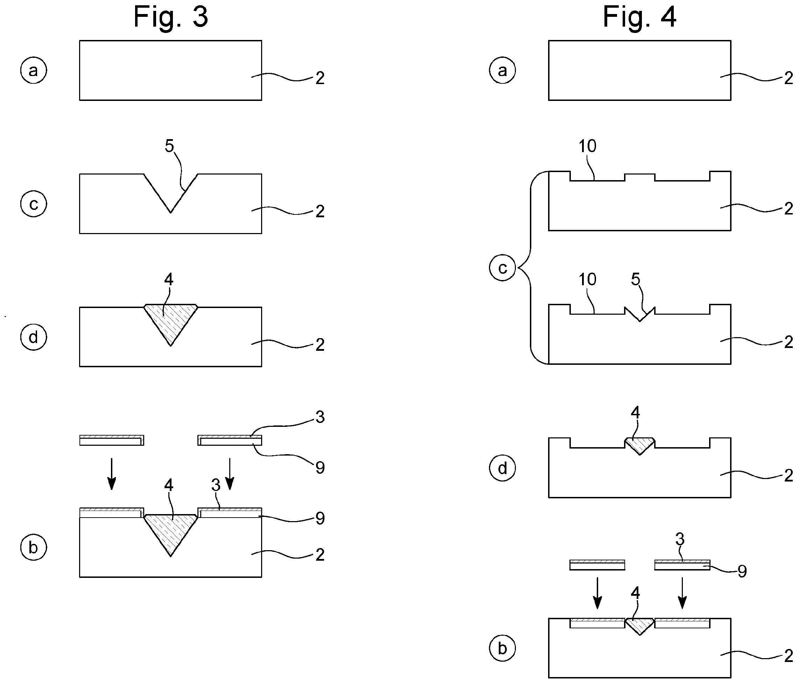

Pour la variante des figures 3 et 4, l'étape b) de dépôt de la couche noire 3, qu'on peut aussi qualifier d'étape d'apport de la couche noire, est réalisée par fixation d'une ou plusieurs plaques 9 revêtues d'une couche noire 3 sur le substrat 2. Les étapes b), c) et d) peuvent être réalisées dans différents ordres. Préférentiellement, la fixation des plaques est réalisée après le positionnement et la fixation de la pierre. A la figure 4, lesdites plaques 9 sont insérées au sein d'évidements 10 ménagés dans le substrat 2 lors de l'étape d'usinage c).

Tous les modes de réalisation sont présentés pour un élément de sertissage qui est recouvert d'une couche noire de manière à se fondre avec le fond du cadran. Cependant, la présente invention n'exclut pas que l'élément de sertissage soit dépourvu de la couche noire.

Pour finir, la présente invention couvre également un ensemble comprenant un premier composant et un second composant chacun destiné à l'habillage intérieur ou au mouvement d'une pièce d'horlogerie ou de bijouterie. Selon l'invention, le premier et le second composants comportent au moins une portion revêtue de la couche noire. Préférentiellement, le premier composant présente un mouvement relatif par rapport au second composant et est monté en regard de ce dernier. Ce premier composant est décoré avec une ou plusieurs pierres. Par exemple, le premier composant est une aiguille revêtue de la couche noire et décorée avec une pierre sertie ou collée au bout de l'aiguille, et le second composant est un cadran revêtu de la couche noire.

### Légende

- (1): Cadran
- (2): Substrat
- (3): Couche noire
- (4): Pierre
- (5): Logement
- (6): Elément de sertissage
- (7): Couche de précurseur
- (9): Plaque
- (10): Evidement

## Revendications

1. Composant d'habillage intérieur ou du mouvement pour une pièce d'horlogerie ou de bijouterie comprenant un substrat (2) revêtu partiellement d'une couche noire (3) et décoré d'au moins une pierre (4) assise dans un logement (5) ménagé dans le substrat (2), ladite couche noire (3) comprenant des nanotubes de carbone ou de l'oxyde d'aluminium, ledit substrat (2) étant au moins dépourvu de la couche noire (3) sur la portion en regard de la pierre (4).

2. Composant selon la revendication 1, **caractérisé en ce que** la couche noire (3) affleure la table de la pierre (4).

3. Composant selon l'une des revendications précédentes, **caractérisé en ce que** ce que la pierre (4) est sertie au sein du logement (5) avec un élément de sertissage (6).

4. Composant selon la revendication précédente, **caractérisé en ce que** ledit élément de sertissage (6) est également revêtu de la couche noire (3).

5. Composant selon la revendication 1, **caractérisé en ce qu'**il comporte plusieurs alignements de pierres (4), la couche noire (3) étant disposée entre les alignements.

6. Composant selon l'une des revendications précédentes, **caractérisé en ce que** la couche noire (3) est un vernis comprenant en poids au moins 1%, de préférence au moins 10% de nanotubes de carbone, lesdits nanotubes de carbone ayant une orientation aléatoire au sein du vernis.

7. Composant selon l'une des revendications 1 à 5, **caractérisé en ce que** la couche noire (3) comporte au moins 50%, au moins 60%, au moins 70%, au moins 80%, au moins 90% en poids de nanotubes de carbone alignés verticalement par rapport au plan du substrat (2), le reste étant constitué d'autres formes de carbone.

8. Composant selon l'une des revendications 1 à 5, **caractérisé en ce que** la couche noire (3) comporte 100% en poids de nanotubes de carbone alignés verticalement par rapport au plan du substrat (2).

9. Composant selon l'une des revendications précédentes, **caractérisé en ce que** la couche noire (3) comprenant des nanotubes de carbone a une épaisseur comprise entre 1 et 100 µm.

10. Composant selon l'une des revendications 1 à 5, **caractérisé en ce que** la couche noire (3) comprend au moins 90% en poids d'oxyde d'aluminium, de préférence 100% en poids d'oxyde d'aluminium.

11. Composant selon la revendication 10, **caractérisé en ce que** l'oxyde d'aluminium a une teneur en poids en aluminium comprise entre 45% et 65 % et de préférence entre 45% et 50%.

12. Composant selon la revendication 10 ou 11, **caractérisé en ce que** la couche noire (3) a une épaisseur comprise entre 1 et 50 microns, de préférence entre 2 et 10 microns, et plus préférentiellement entre 4 et 7 microns.

13. Composant selon l'une des revendications précédentes, **caractérisé en ce qu'**il est choisi parmi le groupe comprenant un cadran, un index, une aiguille, une applique, une masse oscillante, une platine et un pont.

14. Ensemble comprenant le composant selon l'une des revendications précédentes et un autre composant d'habillage intérieur ou du mouvement pour une pièce d'horlogerie ou de bijouterie, ledit autre composant étant revêtu au moins partiellement de ladite couche noire (3).

15. Ensemble selon la revendication précédente, **caractérisé en ce que** le composant est disposé en regard dudit autre composant et monté avec un mouvement relatif par rapport audit autre composant.

16. Ensemble selon la revendication 14 ou 15, **caractérisé en ce que** le composant est une aiguille et **en ce que** l'autre composant est un cadran.

17. Pièce d'horlogerie ou de bijouterie comprenant le composant selon l'une des revendications 1 à 13 ou l'ensemble selon l'une des revendications 14 à 16.

18. Procédé de fabrication d'un composant destiné à l'habillage intérieur ou au mouvement d'une pièce d'horlogerie ou de bijouterie, ledit composant comportant un substrat (2) revêtu au moins partiellement d'une couche noire (3) et décoré avec au moins une pierre (4) assise dans un logement (5) ménagé dans le substrat (2), ladite couche noire (3) comprenant des nanotubes de carbone ou de l'oxyde d'aluminium et ledit substrat (2) étant au moins dépourvu de la couche noire (3) sur la surface du logement (5), le procédé comprenant :
- une étape a) de mise à disposition du substrat (2),
suivie dans un ordre non spécifié d'
- une étape b) de dépôt de la couche noire (3) sur le substrat (2),
- une étape c) d'usinage du logement (5) dans le substrat (2),
- une étape d) de positionnement et fixation de la pierre (4) au sein du logement (5),
ladite étape b) de dépôt étant réalisée sélectivement de manière à ce qu'au moins la surface du logement (5) soit dépourvue de la couche noire (3).

19. Procédé de fabrication selon la revendication 18, **caractérisé en ce qu'**il comporte successivement pour un substrat (2) revêtu d'une couche noire (3) comprenant des nanotubes de carbone :
- l'étape a) de mise à disposition du substrat (2),
- l'étape c) d'usinage du logement (5) dans le substrat (2),
- une étape f) de dépôt et recuit d'une couche d'un précurseur (7) sur le substrat (2), y compris sur la surface du logement (5),
- une étape g) d'enlèvement sélectif de la couche de précurseur (7) déposée sur la surface du logement (5),
- l'étape d) de positionnement et fixation de la pierre (4) au sein du logement (5) du substrat (2),
- l'étape b) de dépôt de la couche noire (3) sur le substrat (2) réalisée de manière sélective sur la couche de précurseur (7).

20. Procédé de fabrication selon la revendication 18, **caractérisé en ce qu'**il comporte successivement pour un substrat (2) revêtu d'une couche noire (3) comprenant des nanotubes de carbone :
- l'étape a) de mise à disposition du substrat (2),
- une étape f) de dépôt et recuit d'une couche d'un précurseur (7) sur le substrat (2),
- l'étape c) d'usinage du logement (5) dans le substrat (2) conduisant à enlever sélectivement la couche de précurseur (7) au niveau du logement (5),
- l'étape d) de positionnement et fixation de la pierre (4) au sein du logement (5) du substrat (2),
- l'étape b) de dépôt de la couche noire (3) sur le substrat (2) réalisée de manière sélective sur la couche de précurseur (7).

21. Procédé de fabrication selon la revendication 18, **caractérisé en ce qu'**il comporte successivement pour un substrat (2) revêtu d'une couche noire (3) comprenant des nanotubes de carbone :
- l'étape a) de mise à disposition du substrat (2),
- l'étape c) d'usinage du logement (5) dans le substrat (2),
- l'étape d) de positionnement et fixation de la pierre (4) au sein du logement (5) du substrat (2),
- une étape f) de dépôt et recuit d'une couche d'un précurseur (7) sur le substrat (2), y compris sur la surface libre de la pierre (4),
- une étape g) d'enlèvement sélectif de la couche de précurseur (7) déposée sur la surface libre de la pierre (4),
- l'étape b) de dépôt de la couche noire (3) sur le substrat (2) réalisée sélectivement sur la couche de précurseur (7).

22. Procédé de fabrication selon l'une des revendications 19 à 21, **caractérisé en ce que** le précurseur comporte un polymère et des nanotubes de carbone.

23. Procédé de fabrication selon la revendication précédente, **caractérisé en ce que** le pourcentage en poids de nanotubes de carbone est compris entre 0.1 et 15% et le pourcentage en poids de polymère est compris entre 85 et 99.9%.

24. Procédé de fabrication selon la revendication 22 ou 23, **caractérisé en ce que** le polymère est choisi parmi un polyamide, un polybutène, un polyéthylène, un polyimide, un polypropylène, un polystyrène, un polyacétate de vinyle, un polyméthacrylate de méthyle, un polyépoxyde et un polyuréthane.

25. Procédé de fabrication selon l'une des revendications 19 à 24, **caractérisé en ce que** la couche de précurseur (7) a une épaisseur comprise entre 10 et 200 microns, de préférence entre 100 et 200 microns.

26. Procédé de fabrication selon la revendication 18, **caractérisé en ce que** l'étape b) de dépôt de la couche noire (3) sur le substrat (2) est réalisée de manière sélective par fixation d'une ou plusieurs plaques (9) revêtues de la couche noire (3) sur le substrat (2).

27. Procédé de fabrication selon la revendication précédente, **caractérisé en ce qu'**il comporte successivement :
- l'étape a) de mise à disposition du substrat (2),
- l'étape c) d'usinage du logement (5) dans le substrat (2),
- l'étape d) de positionnement et fixation de la pierre (4) au sein du logement (5) du substrat (2),
- l'étape b) de dépôt de la couche noire (3) sur le substrat (2) réalisée de manière sélective par fixation d'une ou plusieurs plaques (9) revêtues de la couche noire (3) sur le substrat (2).

28. Procédé de fabrication selon la revendication précédente, **caractérisé en ce que** la ou les plaques (9) sont fixées respectivement dans un ou plusieurs évidements (10) pratiqués dans le substrat (2).

29. Procédé de fabrication selon la revendication 19 ou 21, **caractérisé en ce que** l'étape g) d'enlèvement sélectif de la couche de précurseur (7) est réalisée par ablation laser ou mécaniquement.

30. Procédé de fabrication selon l'une des revendications 18 à 29, **caractérisé en ce que** la couche noire (3) comprenant des nanotubes de carbone est déposée par spray, PVD ou CVD.

31. Procédé de fabrication selon l'une des revendications 18, 26 à 28, **caractérisé en ce que** la couche noire (3) comprenant de l'oxyde d'aluminium est déposée par PVD, CVD ou PECVD.

32. Procédé de fabrication selon l'une des revendications 18 à 31, **caractérisé en ce que** la fixation de la pierre (4) est réalisée par sertissage.

## Patentansprüche

1. Bauteil für die Innenausstattung oder das Uhrwerk einer Uhr oder eines Schmuckstücks, umfassend ein Substrat (2), das teilweise mit einer schwarzen Schicht (3) beschichtet und mit mindestens einem Stein (4) verziert ist, der in einer Lagerung (5) sitzt, die in dem Substrat (2) vorgesehen ist, wobei die schwarze Schicht (3) Kohlenstoffnanoröhren oder Aluminiumoxid umfasst, wobei das Substrat (2) zumindest an dem Abschnitt, der dem Stein (4) zugewandt ist, keine schwarze Schicht (3) aufweist.

2. Bauteil nach Anspruch 1, **dadurch gekennzeichnet, dass** die schwarze Schicht (3) bündig mit der Oberseite des Steins (4) ist.

3. Bauteil nach einem der vorhergehenden Ansprüche, **dadurch gekennzeichnet, dass** der Stein (4) innerhalb der Lagerung (5) mit einem Fassungselement (6) eingefasst ist.

4. Bauteil nach dem vorhergehenden Anspruch, **dadurch gekennzeichnet, dass** das Fassungselement (6) ebenfalls mit der schwarzen Schicht (3) beschichtet ist.

5. Bauteil nach Anspruch 1, **dadurch gekennzeichnet, dass** es mehrere Reihen von Steinen (4) aufweist, wobei die schwarze Schicht (3) zwischen den Reihen angeordnet ist.

6. Bauteil nach einem der vorhergehenden Ansprüche, **dadurch gekennzeichnet, dass** die schwarze Schicht (3) ein Lack ist, der mindestens 1 Gew.-%, vorzugsweise mindestens 10 Gew.-% Kohlenstoffnanoröhren umfasst, wobei die Kohlenstoffnanoröhren eine zufällige Orientierung innerhalb des Lacks aufweisen.

7. Bauteil nach einem der Ansprüche 1 bis 5, **dadurch gekennzeichnet, dass** die schwarze Schicht (3) mindestens 50 Gew.-%, mindestens 60 Gew.-%, mindestens 70 Gew.-%, mindestens 80 Gew.-%, mindestens 90 Gew.-% Kohlenstoffnanoröhren umfasst, die bezüglich der Ebene des Substrats (2) vertikal ausgerichtet sind, wobei der Rest aus anderen Formen von Kohlenstoff besteht.

8. Bauteil nach einem der Ansprüche 1 bis 5, **dadurch gekennzeichnet, dass** die schwarze Schicht (3) 100 Gew.-% Kohlenstoffnanoröhren umfasst, die bezüglich der Ebene des Substrats (2) vertikal ausgerichtet sind.

9. Bauteil nach einem der vorhergehenden Ansprüche, **dadurch gekennzeichnet, dass** die schwarze Schicht (3), die Kohlenstoffnanoröhren umfasst, eine Dicke zwischen 1 und 100 µm aufweist.

10. Bauteil nach einem der Ansprüche 1 bis 5, **dadurch gekennzeichnet, dass** die schwarze Schicht (3) mindestens 90 Gew.-% Aluminiumoxid, vorzugsweise 100 Gew.-% Aluminiumoxid, umfasst.

11. Bauteil nach Anspruch 10, **dadurch gekennzeichnet, dass** das Aluminiumoxid einen Aluminiumgewichtsgehalt zwischen 45 % und 65 % und vorzugsweise zwischen 45 % und 50 % aufweist.

12. Bauteil nach Anspruch 10 oder 11, **dadurch gekennzeichnet, dass** die schwarze Schicht (3) eine Dicke zwischen 1 und 50 Mikron, vorzugsweise zwischen 2 und 10 Mikron und besonders bevorzugt zwischen 4 und 7 Mikron aufweist.

13. Bauteil nach einem der vorhergehenden Ansprüche, **dadurch gekennzeichnet, dass** es ausgewählt ist aus der Gruppe bestehend aus einem Zifferblatt, einem Index, einem Zeiger, einer Applike, einer Schwungmasse, einer Platine und einer Brücke.

14. Anordnung, umfassend das Bauteil nach einem der vorhergehenden Ansprüche und ein weiteres Bauteil für die Innenausstattung oder das Uhrwerk einer Uhr oder eines Schmuckstücks, wobei das weitere Bauteil zumindest teilweise mit der schwarzen Schicht (3) beschichtet ist.

15. Anordnung nach dem vorhergehenden Anspruch, **dadurch gekennzeichnet, dass** das Bauteil gegenüber dem weiteren Bauteil angeordnet und relativ beweglich in Bezug auf das weitere Bauteil montiert ist.

16. Anordnung nach Anspruch 14 oder 15, **dadurch gekennzeichnet, dass** das Bauteil ein Zeiger ist, und dadurch, dass das weitere Bauteil ein Zifferblatt ist.

17. Uhr oder Schmuckstück, umfassend das Bauteil nach einem der Ansprüche 1 bis 13 oder Anordnung nach einem der Ansprüche 14 bis 16.

18. Herstellungsverfahren für ein Bauteil, das für die Innenausstattung oder das Uhrwerk einer Uhr oder eines Schmuckstücks bestimmt ist, wobei das Bauteil ein Substrat (2) umfasst, das teilweise mit einer schwarzen Schicht (3) beschichtet und mit mindestens einem Stein (4) verziert ist, der in einer Lagerung (5) sitzt, die in dem Substrat (2) vorgesehen ist, wobei die schwarze Schicht (3) Kohlenstoffnanoröhren oder Aluminiumoxid umfasst und das Substrat (2) zumindest auf der Oberfläche der Lagerung (5) keine schwarze Schicht (3) aufweist, wobei das Verfahren Folgendes umfasst:
- einen Schritt a) des Bereitstellens des Substrats (2), wobei in nicht festgelegter Reihenfolge Folgendes folgt
- ein Schritt b) des Aufbringens der schwarzen Schicht (3) auf dem Substrat (2),
- ein Schritt c) des Einarbeitens der Lagerung (5) in das Substrat (2),
- ein Schritt d) des Positionierens und Fixierens des Steins (4) innerhalb der Lagerung (5),
wobei der Schritt b) des Aufbringens selektiv ausgeführt wird, so dass zumindest auf der Oberfläche der Lagerung (5) keine schwarze Schicht (3) vorhanden ist.

19. Herstellungsverfahren nach Anspruch 18, **dadurch gekennzeichnet, dass** es nacheinander für ein Substrat (2), das mit einer schwarzen Schicht (3) bestehend aus Kohlenstoffnanoröhren beschichtet ist, Folgendes umfasst:
- Schritt a) des Bereitstellens des Substrats (2),
- Schritt c) des Einarbeitens der Lagerung (5) in das Substrat (2),
- einen Schritt f) des Aufbringens und Ausglühens einer Schicht aus einem Vorläufer (7) auf dem Substrat (2), einschließlich auf der Oberfläche der Lagerung (5),
- einen Schritt g) des selektiven Entfernens der Vorläuferschicht (7), die auf der Oberfläche der Lagerung (5) aufgebracht ist,
- Schritt d) des Positionierens und Fixierens des Steins (4) innerhalb der Aufnahme (5) des Substrats (2),
- Schritt b) des Aufbringens der schwarzen Schicht (3) auf dem Substrat (2), der selektiv auf der Vorläuferschicht (7) durchgeführt wird.

20. Herstellungsverfahren nach Anspruch 18, **dadurch gekennzeichnet, dass** es nacheinander für ein Substrat (2), das mit einer schwarzen Schicht (3) bestehend aus Kohlenstoffnanoröhren beschichtet ist, Folgendes umfasst:
- Schritt a) des Bereitstellens des Substrats (2),
- einen Schritt f) des Aufbringens und Ausglühens einer Schicht aus einem Vorläufer (7) auf dem Substrat (2),
- Schritt c) des Einarbeitens der Lagerung (5) in das Substrat (2), das zum selektiven Entfernen der Vorläuferschicht (7) auf Höhe der Lagerung (5) führt,
- Schritt d) des Positionierens und Fixierens des Steins (4) innerhalb der Lagerung (5) des Substrats (2),
- Schritt b) des Aufbringens der schwarzen Schicht (3) auf dem Substrat (2), der selektiv auf der Vorläuferschicht (7) durchgeführt wird.

21. Herstellungsverfahren nach Anspruch 18, **dadurch gekennzeichnet, dass** es nacheinander für ein Substrat (2), das mit einer schwarzen Schicht (3) bestehend aus Kohlenstoffnanoröhren beschichtet ist, Folgendes umfasst:
- Schritt a) des Bereitstellens des Substrats (2),
- Schritt c) des Einarbeitens der Lagerung (5) in das Substrat (2),
- Schritt d) des Positionierens und Fixierens des Steins (4) innerhalb der Lagerung (5) des Substrats (2),
- einen Schritt f) des Aufbringens und Ausglühens einer Schicht aus einem Vorläufer (7) auf dem Substrat (2), einschließlich auf der freien Oberfläche des Steins (4),
- einen Schritt g) des selektiven Entfernens der Vorläuferschicht (7), die auf der freien Oberfläche des Steins (4) aufgebracht ist,
- Schritt b) des Aufbringens der schwarzen Schicht (3) auf dem Substrat (2), das selektiv auf der Vorläuferschicht (7) durchgeführt wird.

22. Herstellungsverfahren nach einem der Ansprüche 19 bis 21, **dadurch gekennzeichnet, dass** der Vorläufer ein Polymer und Kohlenstoffnanoröhren umfasst.

23. Herstellungsverfahren nach dem vorhergehenden Anspruch, **dadurch gekennzeichnet, dass** der Gewichtsprozentanteil der Kohlenstoffnanoröhren zwischen 0,1 und 15% liegt und der Gewichtsprozentanteil des Polymers zwischen 85 und 99,9 % liegt.

24. Herstellungsverfahren nach Anspruch 22 oder 23, **dadurch gekennzeichnet, dass** das Polymer ausgewählt ist aus einem Polyamid, einem Polybuten, einem Polyethylen, einem Polyimid, einem Polypropylen, einem Polystyrol, einem Polyvinylacetat, einem Polymethylmethacrylat, einem Polyepoxid und einem Polyurethan.

25. Herstellungsverfahren nach einem der Ansprüche 19 bis 24, **dadurch gekennzeichnet, dass** die Vorläuferschicht (7) eine Dicke zwischen 10 und 200 Mikron, vorzugsweise zwischen 100 und 200 Mikron aufweist.

26. Herstellungsverfahren nach Anspruch 18, **dadurch gekennzeichnet, dass** Schritt b) des Aufbringens der schwarzen Schicht (3) auf dem Substrat (2) selektiv durch Fixieren einer oder mehrerer Platten (9), die mit der schwarzen Schicht (3) beschichtet sind, auf dem Substrat (2) durchgeführt wird.

27. Herstellungsverfahren nach dem vorhergehenden Anspruch, **dadurch gekennzeichnet, dass** es nacheinander Folgendes umfasst:
- Schritt a) des Bereitstellens des Substrats (2),
- Schritt c) des Einarbeitens der Lagerung (5) in das Substrat (2),
- Schritt d) des Positionierens und Fixierens des Steins (4) innerhalb der Lagerung (5) des Substrats (2),
- Schritt b) des Aufbringens der schwarzen Schicht (3) auf dem Substrat (2), das selektiv durch Fixieren einer oder mehrerer Platten (9), die mit der schwarzen Schicht (3) beschichtet sind, auf dem Substrat (2) durchgeführt wird.

28. Herstellungsverfahren nach dem vorhergehenden Anspruch, **dadurch gekennzeichnet, dass** die Platte oder die Platten (9) jeweils in einer oder mehreren Vertiefungen (10) befestigt werden, die in dem Substrat (2) ausgebildet sind.

29. Herstellungsverfahren nach Anspruch 19 oder 21, **dadurch gekennzeichnet, dass** der Schritt g) des selektiven Entfernens der Vorläuferschicht (7) durch Laserablation oder mechanisch hergestellt wird.

30. Herstellungsverfahren nach einem der Ansprüche 18 bis 29, **dadurch gekennzeichnet, dass** die schwarze Schicht (3), die Kohlenstoffnanoröhren umfasst, durch Sprühen, PVD oder CVD aufgebracht wird.

31. Herstellungsverfahren nach einem der Ansprüche 18, 26 bis 28, **dadurch gekennzeichnet, dass** die schwarze Schicht (3), die Aluminiumoxid umfasst, durch PVD, CVD oder PECVD aufgebracht wird.

32. Herstellungsverfahren nach einem der Ansprüche 18 bis 31, **dadurch gekennzeichnet, dass** das Fixieren des Steins (4) mittels einer Einfassung durchgeführt wird.

## Claims

1. A component for the internal parts or the movement for a timepiece or a piece of jewellery comprising a substrate (2) partially coated with a black layer (3) and decorated with at least one stone (4) sitting in a housing (5) formed in the substrate (2), said black layer (3) comprising carbon nanotubes or aluminium oxide, said substrate (2) being at least devoid of the black layer (3) on the portion facing the stone (4).

2. The component according to claim 1, **characterised in that** the black layer (3) is flush with the table of the stone (4).

3. The component according to one of the preceding claims, **characterised in that** the stone (4) is set within the housing (5) with a setting element (6).

4. The component according to the preceding claim, **characterised in that** said setting element (6) is also coated with the black layer (3).

5. The component according to claim 1, **characterised in that** it includes several alignments of stones (4), the black layer (3) being disposed between the alignments.

6. The component according to one of the preceding claims, **characterised in that** the black layer (3) is a varnish comprising by weight at least 1%, preferably at least 10% of carbon nanotubes, said carbon nanotubes having a random orientation within the varnish.

7. The component according to one of claims 1 to 5, **characterised in that** the black layer (3) includes at least 50%, at least 60%, at least 70%, at least 80%, at least 90% by weight of carbon nanotubes aligned vertically with respect to the plane of the substrate (2), the remainder consisting of other forms of carbon.

8. The component according to one of claims 1 to 5, **characterised in that** the black layer (3) includes 100% by weight of carbon nanotubes aligned vertically with respect to the plane of the substrate (2).

9. The component according to one of the preceding claims, **characterised in that** the black layer (3) comprising carbon nanotubes has a thickness comprised between 1 and 100 µm.

10. The component according to one of claims 1 to 5, **characterised in that** the black layer (3) comprises at least 90% by weight of aluminium oxide, preferably 100% by weight of aluminium oxide.

11. The component according to claim 10, **characterised in that** the aluminium oxide has an aluminium content by weight comprised between 45% and 65% and preferably between 45% and 50%.

12. The component according to claim 10 or 11, **characterised in that** the black layer (3) has a thickness comprised between 1 and 50 microns, preferably between 2 and 10 microns, and more preferably between 4 and 7 microns.

13. The component according to one of the preceding claims, **characterised in that** it is selected from the group comprising a dial, an index, a hand, an applique, an oscillating mass, a platen and a bridge.

14. An assembly comprising the component according to one of the preceding claims and another component for the internal parts or the movement for a timepiece or a piece of jewellery, said other component being at least partially coated with said black layer (3).

15. The assembly according to the preceding claim, **characterised in that** the component is disposed facing said other component and mounted with a relative movement with respect to said other component.

16. The assembly according to claim 14 or 15, **characterised in that** the component is a hand and **in that** the other component is a dial.

17. A timepiece or a piece of jewellery comprising the component according to one of claims 1 to 13 or the assembly according to one of claims 14 to 16.

18. A method for manufacturing a component intended for the internal parts or the movement of a timepiece or a piece of jewellery, said component including a substrate (2) at least partially coated with a black layer (3) and decorated with at least one stone (4) sitting in a housing (5) formed in the substrate (2), said black layer (3) comprising carbon nanotubes or aluminium oxide and said substrate (2) being at least devoid of the black layer (3) on the surface of the housing (5), the method comprising:
- a step a) of providing the substrate (2),
followed in an unspecified order by
- a step b) of depositing the black layer (3) on the substrate (2),
- a step c) of machining the housing (5) in the substrate (2),
- a step d) of positioning and fixing the stone (4) within the housing (5), said deposition step b) being carried out selectively so that at least the surface of the housing (5) is devoid of the black layer (3).

19. The manufacturing method according to claim 18, **characterised in that** it includes successively for a substrate (2) coated with a black layer (3) comprising carbon nanotubes:
- the step a) of providing the substrate (2),
- the step c) of machining the housing (5) in the substrate (2),
- a step f) of depositing and annealing a layer of a precursor (7) on the substrate (2), including on the surface of the housing (5),
- a step g) of selectively removing the precursor layer (7) deposited on the surface of the housing (5),
- the step d) of positioning and fixing the stone (4) within the housing (5) of the substrate (2),
- the step b) of depositing the black layer (3) on the substrate (2) carried out selectively on the precursor layer (7).

20. The manufacturing method according to claim 18, **characterised in that** it includes successively for a substrate (2) coated with a black layer (3) comprising carbon nanotubes:
- the step a) of providing the substrate (2),
- a step f) of depositing and annealing a layer of a precursor (7) on the substrate (2),
- the step c) of machining the housing (5) in the substrate (2) leading to selectively removing the precursor layer (7) at the housing (5),
- the step d) of positioning and fixing the stone (4) within the housing (5) of the substrate (2),
- the step b) of depositing the black layer (3) on the substrate (2) carried out selectively on the precursor layer (7).

21. The manufacturing method according to claim 18, **characterised in that** it includes successively for a substrate (2) coated with a black layer (3) comprising carbon nanotubes:
- the step a) of providing the substrate (2),
- the step c) of machining the housing (5) in the substrate (2),
- the step d) of positioning and fixing the stone (4) within the housing (5) of the substrate (2),
- a step f) of depositing and annealing a layer of a precursor (7) on the substrate (2), including on the free surface of the stone (4),
- a step g) of selectively removing the precursor layer (7) deposited on the free surface of the stone (4),
- the step b) of depositing the black layer (3) on the substrate (2) carried out selectively on the precursor layer (7).

22. The manufacturing method according to one of claims 19 to 21, **characterised in that** the precursor includes a polymer and carbon nanotubes.

23. The manufacturing method according to the preceding claim, **characterised in that** the percentage by weight of carbon nanotubes is comprised between 0.1 and 15% and the percentage by weight of polymer is comprised between 85 and 99.9%.

24. The manufacturing method according to claim 22 or 23, **characterised in that** the polymer is selected from a polyamide, a polybutene, a polyethylene, a polyimide, a polypropylene, a polystyrene, a polyvinyl acetate, a polymethyl methacrylate, a polyepoxide and a polyurethane.

25. The manufacturing method according to one of claims 19 to 24, **characterised in that** the precursor layer (7) has a thickness comprised between 10 and 200 microns, preferably between 100 and 200 microns.

26. The manufacturing method according to claim 18, **characterised in that** step b) of depositing the black layer (3) on the substrate (2) is carried out selectively by fixing one or more plates (9) coated with the black layer (3) on the substrate (2).

27. The manufacturing method according to the preceding claim, **characterised in that** it includes successively:
- the step a) of providing the substrate (2),
- the step c) of machining the housing (5) in the substrate (2),
- the step d) of positioning and fixing the stone (4) within the housing (5) of the substrate (2),
- the step b) of depositing the black layer (3) on the substrate (2) carried out selectively by fixing one or more plates (9) coated with the black layer (3) on the substrate (2).

28. The manufacturing method according to the preceding claim, **characterised in that** the plate(s) (9) is/are respectively fixed in one or more recesses (10) made in the substrate (2).

29. The manufacturing method according to claim 19 or 21, **characterised in that** step g) of selectively removing the precursor layer (7) is carried out by laser ablation or mechanically.

30. The manufacturing method according to one of claims 18 to 29, **characterised in that** the black layer (3) comprising carbon nanotubes is deposited by spray, PVD or CVD.

31. The manufacturing method according to one of claims 18, 26 to 28, **characterised in that** the black layer (3) comprising aluminium oxide is deposited by PVD, CVD or PECVD.

32. The manufacturing method according to one of claims 18 to 31, **characterised in that** the fixing of the stone (4) is carried out by setting.
